(19) Europäisches Patentamt

European Patent Office

Office européen des brevets

(11) Publication number: **0 169 021**
A2

# (12) EUROPEAN PATENT APPLICATION

(21) Application number: **85304908.8**

(22) Date of filing: **10.07.85**

(51) Int. Cl.⁴: **H 03 K 17/60**, H 03 K 17/687

(30) Priority: **18.07.84 GB 8418341**

(71) Applicant: **SILICONIX LIMITED, Llanllienwen Close, Morriston Swansea SA6 6NE (GB)**

(43) Date of publication of application: **22.01.86 Bulletin 86/4**

(72) Inventor: **Jenkins, James Oliver Michael, 538 Clydach Road Ynystawe, Swansea Wales (GB)**

(74) Representative: **Cross, Rupert Edward Blount et al, BOULT, WADE & TENNANT 27 Furnival Street, London EC4A 1PQ (GB)**

(84) Designated Contracting States: **BE DE FR GB IT NL**

(54) **Solid state switch.**

(57) A two pole solid state switch has a pair of series connected switching transistors (5 and 6) in each pole. Input lines (7 and 8) are isolated from output lines (9 and 10) by making the switching transistors (5 and 6) non conducting. Additional switches which are preferably additional switching transistors (12 and 13) are arranged between the interconnection points (P) of the switching transistors of each pair in the respective poles of the switch. The additional switching transistors (12 and 13) are put into a highly conducting state whenever the pairs of switching transistors (5 and 6) in the poles of the switch are in a non conducting state. As a result the effective isolation provided by the switch is greatly enhanced.

EP 0 169 021 A2

## SOLID STATE SWITCH

This invention relates to two pole solid state switches.

Two pole solid state switches can be employed to switch a pair of voltage carrying lines in a circuit, for example at the input to a telephone instrument. Preferably, the resistance in the "on" state should be small whereas the isolation in the "off" state should be high. For example, tele - communication switches require a low resistance in the "on" state with 240 volt breakdown and a high degree of isolation between the input and output of the switch in the "off" state.

Known two pole solid state switches employ bi- directional MOS transistor switches for each pole. To achieve the required low resistance in the "on" state the channel area is increased resulting thereby in an overall larger geometry. However, in achieving the low resistance the isolation in the "off" state is reduced due to capacitive components.

0169021

- 2 -

It is an object of the invention to provide a two pole solid state switch employing switching transistors wherein the above-mentioned drawback regarding isolation in the "off" state is reduced.

According to the invention there is provided a two pole solid state switch having first and second poles comprising respective pairs of series linked switching transistors switchable between conducting and non-conducting states and means for connecting the two poles together between the interconnection points of the switching transistors of each pair, in response to all the switching transistors assuming a non-conducting state. By connecting the two poles together between the interconnection points of the switching transistors of each pair the isolation between the two sides of the switch in the "off" state is improved. Consequently, the channel area of the transistors can be increased to achieve an improved resistance in the "on" state without the drawback of reduced isolation in the "off" state. Consequently, the switch according to the invention is particularly suitable for high voltage crosspoint matrices in telephone switching, in general bidirectional switching networks requiring a high degree of "off" isolation or as high voltage analogue switches. Connecting together the two poles does not provide a shunt path between the two poles at audio frequencies.

Conveniently, the two pole solid state switch includes floating driver means connected to switch the respective pairs of switching transistors between said states. In this way, the switching circuit is isolated from the voltage switched by the two pole solid state switch.

Preferably, the two pole solid state switch has said means for connecting comprising a switch means having an intrinsic impedance and actuating means connected to switch the switch means between non-conducting and conducting states in response to all the switching transistors assuming a non-conducting state. For example, the switch means can comprise a pair of series linked switching transistors and the actuating means can comprise a floating driver means. Thus, the switch means operates in antiphase to the switching of the transistor pairs comprising each pole and the use of switching transistors as switches in the two pole solid state switch allows easy construction. Conveniently, the switching transistors comprise MOSFET transistors.

The solid state switch according to the invention can be integrated by forming the switch as an integrated circuit on a semiconductive substrate wherein the first pole, second pole, and means for connecting are dielectrically isolated from each other. Alternatively, the two pole solid state switch according to the invention can be formed as a monolithically integrated circuit on a semiconductive substrate wherein the pair of transistors comprising one pole and one of the transistors comprising the switch means are formed as a discrete unit on the substrate. Consequently, a cost effective production of a small size two pole solid state switch is achieved.

The two pole solid state switch according to the present invention can be conveniently employed in telephone apparatus because of the improved "off" isolation whilst maintaining the other required characteristics of low "on" resistance and high voltage breakdown.

The present invention will now be described, by way of example only, with reference to the accompanying drawings, in which:

Figure 1 illustrates a known two pole solid state switch connected in the subscriber line interface circuit of a telephone exchange.

Figure 2 illustrates the equivalent circuit of the solid state switch shown in Figure 1.

Figure 3 illustrates a two pole solid state switch embodying the present invention.

Figure 4 illustrates a further two pole solid state switch embodying the present invention.

Figure 5 illustrates an equivalent circuit of the two pole solid state switches shown in Figures 3 and 4.

Figure 6 illustrates a discrete unit for integration to form the solid state switch shown in Figure 4.

Figure 7 shows a diagrammatic representation of the integration of the discrete unit shown in Figure 6.

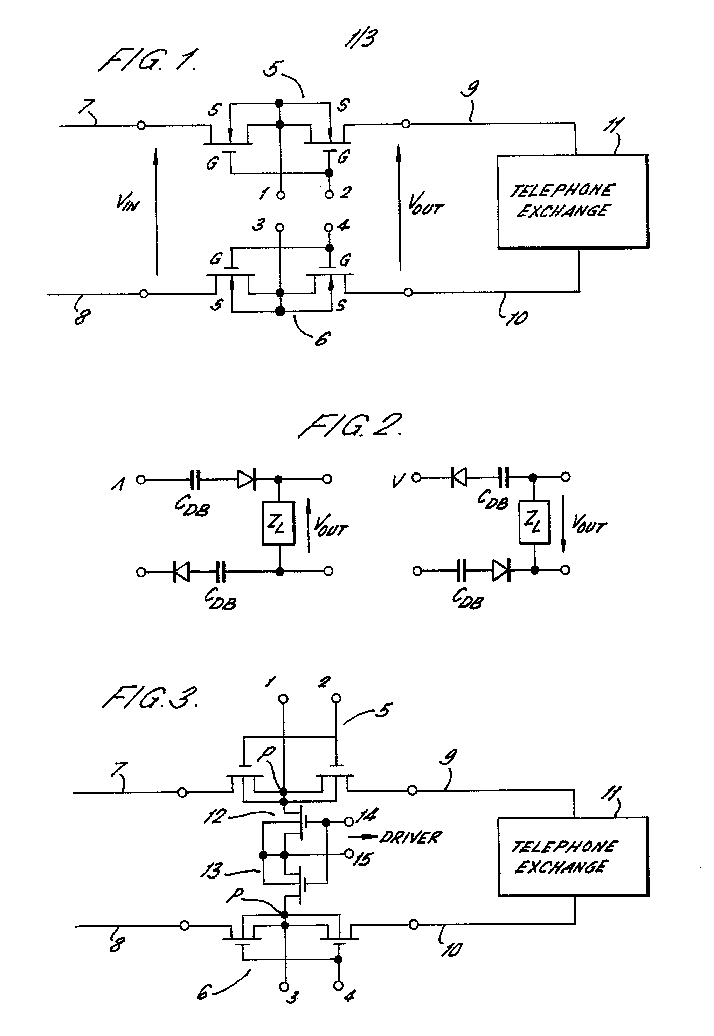

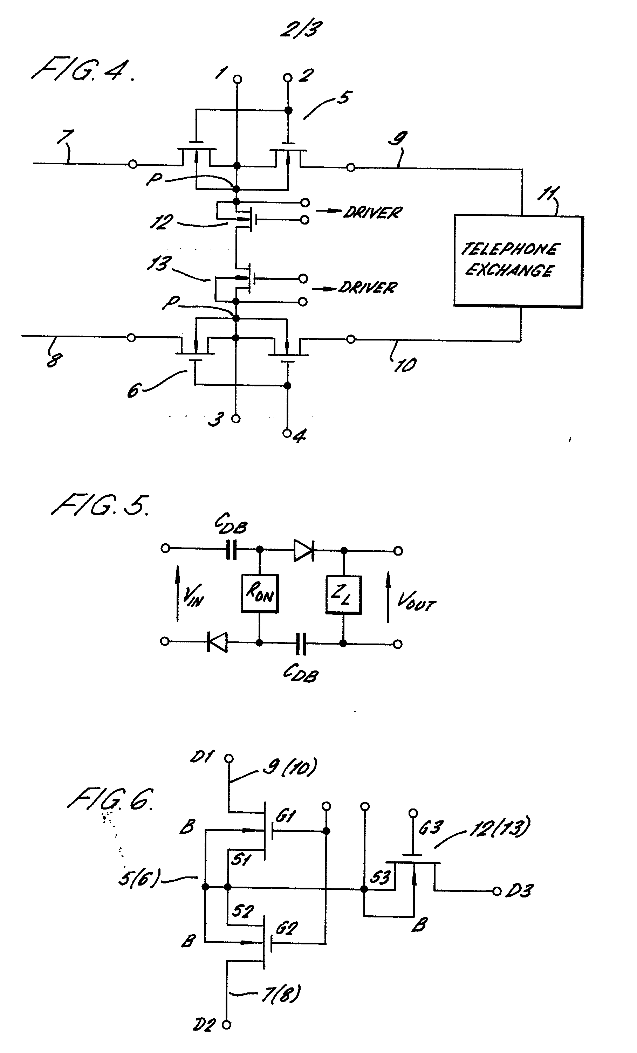

Referring to Figures 1 and 2, a known two pole solid state switch has a pair of poles 5 and 6 each comprising a pair of MOS switches connected together in a known manner to be driven by floating drivers (not shown) connected to terminals 1 to 4. The solid state switch is connected to input lines 7 and 8 and output lines 9 and 10 leading to a telephone exchange 11. The voltage appearing across input lines 7 and 8 is $V_{in}$ and the voltage appearing across lines 9 and 10 is $V_{out}$. The isolation of the solid state switch in the "off" state is given by the ratio of $V_{out}/V_{in}$

with both poles 5 and 6 in a non-conducting state.

The equivalent circuit of Figure 1 is shown in Figure 2.

Analyzing the equivalent circuit and assuming ZDB is very much greater than ZL then

$$Vout \approx \frac{ZL}{2ZDB} \cdot Vin$$

where $ZDB = \frac{1}{Jw\ CDB}$

where W = frequency and CDB = drain - body capacitance of each pole and ZL = the impedance of the load across the lines 9 and 10.

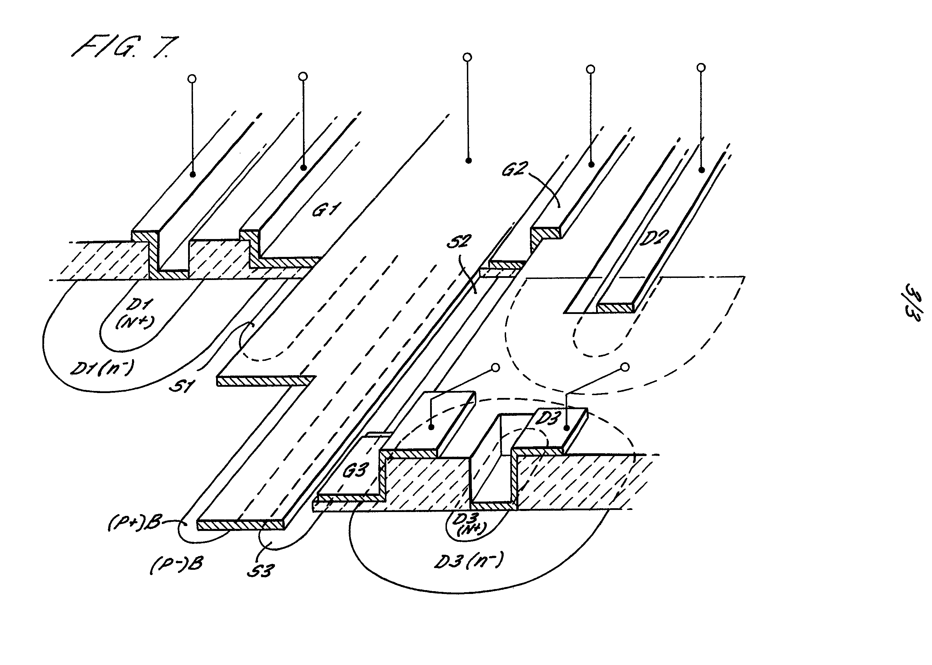

Referring to Figures 3 and 4 wherein items common to Figure 1 bear the same reference numeral, the solid state switch further includes a pair of MOS transistors 12 and 13 connected together in known manner to form a switch. The pair of transistors 12 and 13 are connected between the two poles 5 and 6 between the interconnection points P of the transistors forming the poles 5 and 6. The pair of transistors 12 and 13 have a pair of terminals 14 and 15 connected to a floating driver (not shown) whereby application of a voltage pulse to terminals 14 and 15 can switch the pair of transistors 12 and 13 into a conducting state to thereby short circuit together the two interconnection points P.

Figure 5 illustrates an equivalent circuit corresponding to Figures 3 and 4. By analyzing the circuit shown in Figure 5 it will be apparent that

$$Vout \approx \frac{ZL}{ZDB} \cdot \frac{Ron}{ZDB} \quad (vin)$$

where Ron is equal to the intrinsic resistance of the switch connected across the interconnection points P and ZDB is very much greater than ZL.

It will be apparent from the above pair of equations that the improvement in "off" isolation by connecting the pair of transistors 12 and 13 across the interconnection points P is

$$\frac{ZDB}{2Ron}$$

Typically, Ron = 1K and CDB = 30 pF. Therefore, at a frequency W of 3 kilohertz the "off" isolation is improved by a factor of 1,000. Thus connecting together the two interconnection points p can improve the "off" isolation of the two pole solid state switch by a large order of magnitude.

Figure 4 illustrates an alternative two pole solid state switch wherein each switching transistor 12 and 13 includes respective terminals connected to a floating driver (not shown). In this way, a discrete unit as shown in Figure 6 is produced. By employing this discrete unit as a basic structure for the two pole solid state switch it is possible to produce half the two pole solid state switch as an integrated chip. Naturally, the two pole solid state switch shown in Figure 3 can be produced as 3 separate devices on a chip by employing dielectrically isolated processing.

Figure 7 illustrates a diagrammatic representation of a chip corresponding to Figure 6 which can be integrated monolithically. Two chips can then be employed to construct a two pole solid state switch as shown in Figure 4. The floating driver units required for the switching transistors can also be monolithically integrated.

Consequently, the two pole solid state switch according to the invention results in a large improvement in "off" isolation compared with hitherto known two pole solid state switches. Therefore, the solid state switch can be applied to high voltage crosspoint matrices in telephone switching, or in conjunction with general bidirectional switching networks requiring a high degree of "off" isolation, or applied to high voltage analogue switches. It will be apparent that the switching transistors 12 and 13 can be replaced by an alternative solid state switch and switching transistors other than MOS transistors can be employed.

CLAIMS:

1. A two pole solid state switch having first and second poles comprising respective pairs of series linked switching transistors switchable between conducting and non-conducting states and means for connecting the two poles together between the interconnection points of the switching transistors of each pair, in response to all the switching transistors assuming a non-conducting state.

2. A switch as claimed in Claim 1 including floating driver means connected to switch the respective pairs of switching transistors between said states.

3. A switch as claimed in Claim 1 or 2 wherein said means for connecting comprises a switch means having an intrinsic impedance and actuating means connected to switch the switch means between non-conducting and conducting states in response to all the switching transistors assuming a non-conducting state.

4. A switch as claimed in Claim 3 wherein the switch means comprises a pair of series linked switching transistors and the actuating means comprises a floating driver means.

5. A switch as claimed in any preceding claim wherein said switching transistors comprise MOSFET transistors.

6. A switch as claimed in any preceding claim formed as an integrated circuit on a semiconductive substrate wherein the first pole, second pole, and means for connecting are dielectrically isolated from each other.

7. A switch as claimed in Claim 4 or 5 formed as a monolithically integrated circuit on a semiconductive substrate wherein the pairs of transistors comprising one pole and one of the transistors comprising the switch means are formed as a discrete unit on the substrate.

8. Telephone apparatus including a two pole solid state switch as claimed in any preceding claim.

0169021

FIG. 1.

FIG. 2.

FIG. 3.

FIG.4.

FIG.5.

FIG.6.

FIG. 7.